# EUROPEAN PATENT APPLICATION

(11) **EP 2 599 846 A1**
(43) Date of publication of application: **05.06.2013**
(21) Application number: 12193998.7
(22) Date of filing: 23.11.2012
(51) Int. Cl.: C09J 7/02, C09J 9/02

(54) **Conductive adhesive sheet, method for producing the same, collector electrode, and solar cell module**

(30) Priority: 01.12.2011 JP 2011263576
(71) Applicant: NITTO DENKO CORPORATION, Ibaraki-shi, Osaka 567-8680 (JP)
(72) Inventor: Yamazaki, Hiroshi, Osaka, 567-8680 (JP); Kameyama, Kojiro, Osaka, 567-8680 (JP); Matsumura, Takeshi, Osaka, 567-8680 (JP); Toyoda, Eiji, Osaka, 567-8680 (JP)
(74) Representative: HOFFMANN EITLE

(57) **Abstract**

A conductive adhesive sheet includes a conductor layer including a projecting region that projects curvedly toward at least one side in the thickness direction; a low-melting-point metal layer that is formed on at least one surface in the thickness direction of the projecting region; and an adhesive layer formed on at least one surface in the thickness direction of the low-melting-point metal layer.

## Description

### BACKGROUND OF THE INVENTION

### Field of the Invention

The present invention relates to a conductive adhesive sheet, a method for producing the same, a collector electrode, and a solar cell module. In particular, the present invention relates to a method for producing a conductive adhesive sheet; a conductive adhesive sheet obtained by the method; a collector electrode composed of the conductive adhesive sheet; and a solar cell module including the collector electrode.

### Description of Related Art

Conventionally, conductive adhesive sheets having both conductivity and adhesiveness have been used for connection between connection terminals of various electrical devices.

For example, Japanese Examined Patent Publication Sho 47-51798 proposed a conductive adhesive sheet including an electrically conductive backing and an adhesive layer that covers the surface thereof, wherein acute-angled projections are formed on the front side of the electrically conductive backing.

In the adhesive sheet of Japanese Examined Patent Publication Sho 47-51798, the adhesive layer on the surface of the projections is formed so that its thickness causes electric breakdown. When the adhesive layer is allowed to adhere to the substrate, and electric current flows in the substrate, electric breakdown is caused in the above-described adhesive layer, and in this manner, the substrate and the electrically conductive backing are electrically connected through the adhesive layer.

### SUMMARY OF THE INVENTION

However, in the adhesive sheet of Japanese Examined Patent Publication Sho 47-51798, the projections may pierce the adhesive layer by the pressing force (urging force) at the time of adhesion, and may directly contact the substrate, and in such a case, the top portion (distal end) of the acute-angled projections may disadvantageously damage the substrate.

Also, the projections are directly in contact only with the substrate, and furthermore, the contact area with the substrate cannot be ensured sufficiently. Therefore, electrical connection therebetween is not improved sufficiently, and thus conductivity thereof may become insufficient.

An object of the present invention is to provide a conductive adhesive sheet with excellent conductivity and less damage to adherends; a manufacturing method thereof; a collector electrode; and a solar cell module.

A conductive adhesive sheet of the present invention includes
a conductor layer including a projecting region that projects curvedly toward at least one side in the thickness direction;
a low-melting-point metal layer that is formed on at least one surface in the thickness direction of the projecting region; and
an adhesive layer formed on at least one surface in the thickness direction of the low-melting-point metal layer.

In the conductive adhesive sheet of the present invention, it is preferable that the low-melting-point metal layer is composed of tin and/or a tin-bismuth alloy.

In the conductive adhesive sheet of the present invention, it is preferable that the conductor layer is composed of copper.

In the conductive adhesive sheet of the present invention, it is preferable that the projecting region comprises a plurality of projecting regions disposed in a direction perpendicular to the thickness direction in spaced-apart relation to each other.

A collector electrode for collecting carriers generated in a solar cell of the present invention is composed of the above-described conductive adhesive sheet.

A solar cell module of the present invention includes a solar cell, and the above-described collector electrode.

A method for producing a conductive adhesive sheet of the present invention includes
preparing a conductor plate;
transferring an adhesive layer laminated on a release sheet on at least one surface in the thickness direction of the conductor plate, thereby producing a laminate having the conductor plate, the adhesive layer, and the release sheet that are sequentially laminated; and
pressing the laminate with a mold in the thickness direction, thereby forming a conductor layer including a projecting region that projects curvedly toward at least one side in the thickness direction.

In the method for producing a conductive adhesive sheet of the present invention, it is preferable that in the step of preparing the conductor plate, the conductor plate is provided with a low-melting-point metal layer formed on at least one surface in the thickness direction.

In the conductive adhesive sheet of the present invention, a low-melting-point metal layer and an adhesive layer are sequentially laminated on one side in the thickness direction of the conductor layer. Thus, by allowing the conductive adhesive sheet to abut on an adherend disposed on one side in the thickness direction thereof, the low-melting-point metal layer and the adhesive layer at the projecting regions that project toward one side in the thickness direction are brought into contact with the adherend, and then the projecting regions are brought into contact with the adherend while pushing aside the low-melting-point metal layer and the adhesive layer. Furthermore, the projecting regions are projecting curvedly (i.e., convexly), and therefore concentration of excessive stress on the adherend can be relaxed.

Thus, damages on the adherend can be suppressed.

Also, the contact area between the projecting regions that project curvedly and the adherend can be made relatively large, and therefore excellent conductivity therebetween can be ensured.

Moreover, the adhesive layer can ensure the contact state with the adherend, and therefore the conductive adhesive sheet is allowed to adhere reliably to the adherend.

Furthermore, by melting the metal that forms the low-melting-point metal layer, the projecting region and the adherend are strongly bonded, and therefore even more excellent conductivity can be ensured.

Furthermore, the collector electrode of the present invention composed of the conductive adhesive sheet of the present invention achieves less damage to solar cells, and ensures collection of carriers generated in solar cells. Thus, the solar cell module of the present invention including the solar cell and the collector electrode is excellent in power generation efficiency.

In a method for producing a conductive adhesive sheet of the present invention, a laminate in which a conductor plate, an adhesive layer, and a release sheet laminated sequentially is produced. That is, the adhesive layer is sandwiched in the thickness direction and supported by the conductor plate and the release sheet. Thus, even if the laminate is pressed in the thickness direction with a mold, pushing of the adhesive layer over to the surrounding region from the region where the projecting region is formed can be suppressed, allowing formation of the projecting regions with the adhesive layer remaining.

Furthermore, the release sheet prevents contamination by the adhesive layer adhering to the surrounding members.

### BRIEF DESCRIPTION OF THE DRAWINGS

FIG. 1 shows a perspective view of a conductive adhesive sheet in an embodiment of the present invention.
FIG. 2 is a process drawing for illustrating a method for producing the conductive adhesive sheet shown in FIG. 1,
   (a) illustrating a step of preparing a conductor plate;
   (b) illustrating a step of forming a low-melting-point metal layer;
   (c) illustrating a step of transferring an adhesive layer; and
   (d) illustrating a step of forming projecting regions.
FIG. 3 shows a perspective view of a solar cell module in an embodiment (embodiment in which photoelectric conversion portions are amorphous silicon-based) of the present invention.
FIG. 4 shows an enlarged perspective view illustrating a connection structure (left-side portion) between terminals and the collector electrodes.
FIG. 5 shows a side sectional view of the connection structure of FIG. 4.
FIG. 6 shows a front cross-sectional view of the connection structure of FIG. 4,
   (a) illustrating a state in which the adhesive layer at the top portion is in contact with the terminal, and
   (b) illustrating a state in which the adhesive layer is pushed out, and the top portions are in contact with the terminal.
FIG. 7 shows a perspective view of the conductive adhesive sheet in another embodiment (embodiment in which the projecting regions include an upper portion and a lower portion) of the present invention.
FIG. 8 shows a perspective view of the solar cell module in another embodiment (embodiment in which the photoelectric conversion portions are crystalline silicon-based) of the present invention.
FIG. 9 shows a plan view of the solar cell module shown in FIG. 8.
FIG. 10 shows an enlarged view of the solar cell module shown in FIG. 9, i.e., a side sectional view taken along line A-A.
FIG. 11 shows a cross-sectional view of the conductive adhesive sheet in another embodiment of the present invention.

### DETAILED DESCRIPTION OF THE INVENTION

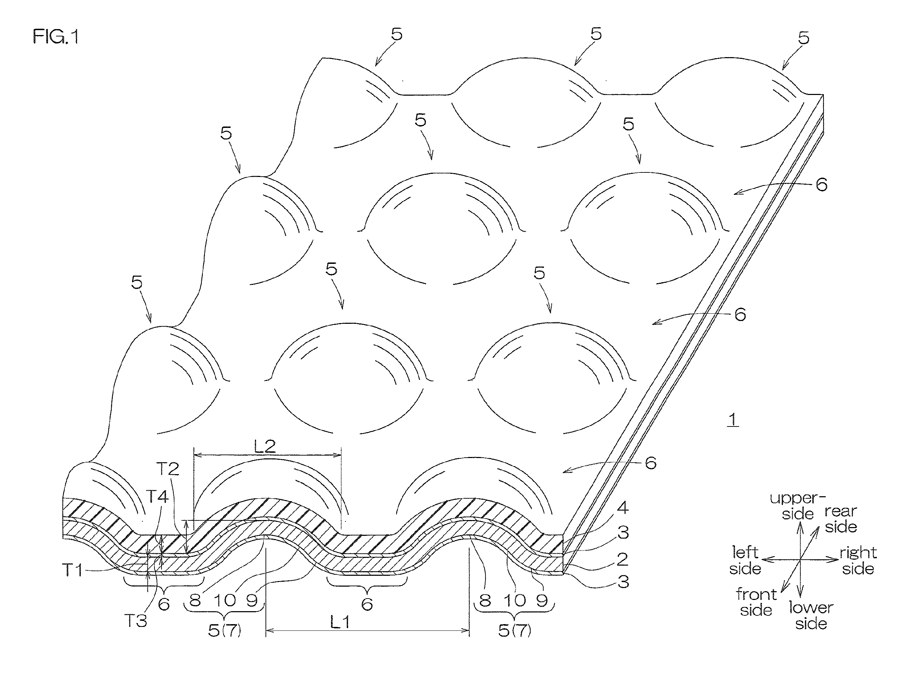

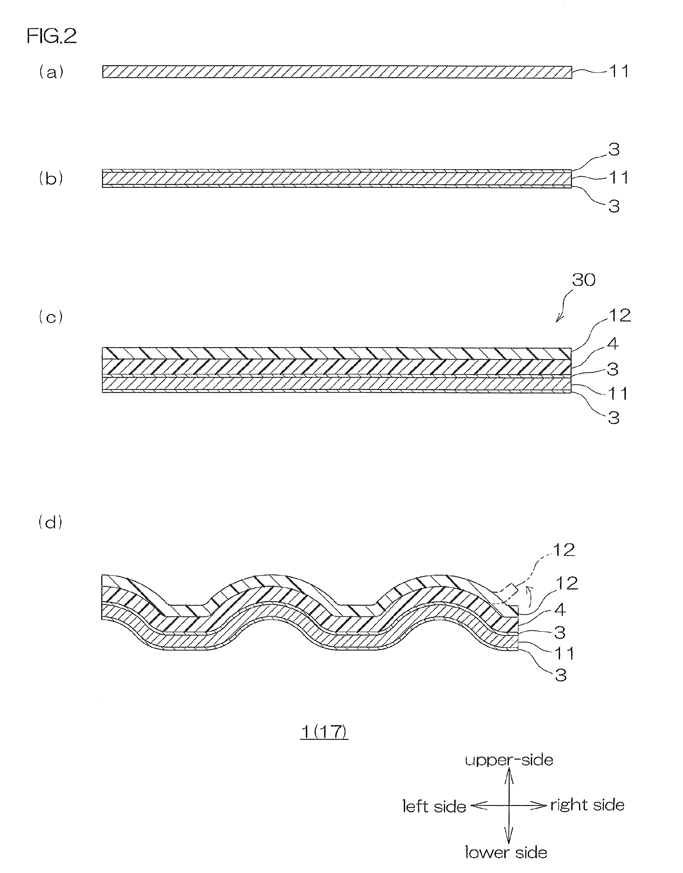

FIG. 1 shows a perspective view of a conductive adhesive sheet in an embodiment of the present invention, and FIG. 2 shows a process drawing for illustrating a method for producing the conductive adhesive sheet shown in FIG. 1.

The directions in Figures that follow are in conformity with the directions shown in FIG. 1.

In FIG. 1, the electrically conductive adhesive sheet 1 is formed into an elongated sheet extending in front-rear directions, and includes a electrically conductor layer 2, a low-melting-point metal layer 3 formed on the conductor layer 2, and an adhesive layer 4 formed on the low-melting-point metal layer 3.

The conductor layer 2 is formed into a sheet including projecting regions 5, which are projecting curvedly toward the upper side from portions of the flat plate. To be specific, the conductor layer 2 integrally includes a plurality of projecting regions 5, which bulge upwardly so as to have a circular arc cross section (generally semicircular arc cross section); and joint regions 6, which connect lower end portions of the plurality of projecting regions 5.

The plurality of projecting regions 5 are arranged in line in spaced-apart relationship to each other in front-rear directions and left-right directions (directions perpendicular to the thickness direction) when viewed from the top, and each of the projecting regions 5 is formed into a generally circular shape when viewed from the top. Each of the projecting regions 5 includes an upper portion 7, which project upwardly from the joint region 6 to be described next when projected (superimposed) in the surface directions (front-rear directions and left-right directions).

The uppermost portion of the upper portion 7 is a top portion 8; the lowermost portion (lower end portion) of the upper portion 7 is a bottom portion (rising portion) 9; and the portion between the top portion 8 and the bottom portion 9 is a middle portion 10.

The joint regions 6 form a generally flat plate that connects the projecting regions 5. To be specific, the joint regions 6 connect the plurality of bottom portions 9.

The size of the conductor layer 2 is suitably selected, and for example, the conductor layer 2 has a thickness T1 of 18 to 150 µm, preferably 25 to 100 µm. The length between the upper surface of the top portion 8 and the upper surface of the bottom portion 9 (that is, projection length) T2 is, for example, 0.05 to 0.8 mm, preferably 0.1 to 0.5 mm.

Length L1 between the top portions 8 in left-right directions is, that is, pitch L1 between the top portions 8 in left-right directions is, for example, 0.5 to 2.0 mm, preferably 0.5 to 1.5 mm. When pitch L1 of the top portions 8 is more than the above-described range, the adhesion area of the top portion 8 to the adherend (described later) decreases, and a conductive adhesive sheet 1 having a large width may be required, whereas when pitch L1 of the top portion 8 is below the above-described range, highly precise working technique may be necessary and costs may be increased.

The length between the top portions 8 in front-rear directions, that is, the pitch between the top portions 8 in front-rear directions is, for example, the same as that of the above-described pitch L1 between the top portions 8 in left-right directions.

The projecting region 5 has external diameter L2 of, for example, 0.2 to 3 mm, preferably 0.5 to 1.5 mm.

When viewed in cross section, radius of curvature R of the circular arc of the upper portion 7 is, for example, 0.1 to 2.0 mm, preferably 0.1 to 1.0 mm.

The low-melting-point metal layer 3 is formed into a thin film laminated on the entire upper surface of the conductor layer 2 including projecting regions 5.

The low-melting-point metal layer 3 is formed also on the lower surface of the conductor layer 2, and the low-melting-point metal layer 3 is formed into a thin film laminated on the entire lower surface of the conductor layer 2.

The low-melting-point metal layer 3 has a thickness T3 of, for example, 3 to 50 µm, preferably 5 to 20 µm.

The adhesive layer 4 is formed on the entire upper surface of the upper-side low-melting-point metal layer 3.

The adhesive layer 4 has a thickness T4 of, for example, 5 to 100 µm, preferably 25 to 50 µm. When the thickness T4 of the adhesive layer 4 is more than the above-described range, the top portion 8 may not push aside easily the adhesive layer 4 when allowing the conductive adhesive sheet 1 to abut on the adherend. When the thickness T4 of the adhesive layer 4 is below the above-described range, adhesive strength of the conductive adhesive sheet 1 to the adherend decreases, which may reduce reliability.

Next, description is given below of a method for producing the conductive adhesive sheet 1 with reference to FIG. 2.

In the method, first, as shown in FIG. 2 (a), a conductor plate 11 is prepared.

The conductor plate 11 is an elongated sheet extending in front-rear directions, and examples of conductors that form the conductor plate 11 include copper, aluminum, nickel, silver, iron, lead, and an alloy thereof. Of these, in view of conductivity, costs, and processability, copper or aluminum is used preferably, and more preferably, copper is used.

Next, in this method, as shown in FIG. 2 (b), the low-melting-point metal layers 3 are formed on the upper surface and the lower surface of conductor plate 11.

Examples of metals that form the low-melting-point metal layer 3 include at least one metal selected from tin, bismuth, and indium; and an alloy of at least two metals selected therefrom. Preferably, tin, or a tin-bismuth alloy is used.

The tin-bismuth alloy has a bismuth concentration of, for example, 10 to 60 mass%.

The above-described alloy has a melting point lower than the melting points of the metals that form the alloy, to be specific, 120 to 180°C.

The low-melting-point metal layer 3 can be formed, for example, by plating or sputtering the above-described metal, preferably by plating, and more preferably by electrolytic plating.

For the conductor plate (conductor plate with low-melting-point metal layers) 11 already including the low-melting-point metal layers 3 provided on its upper surface and the lower surface shown in FIG. 2 (b), a commercially available product may be used.

Next, in this method, as shown in FIG. 2 (c), the adhesive layer 4 is formed on the upper surface of the low-melting-point metal layer 3, which is formed on the upper surface of the conductor plate 11.

Examples of adhesive materials that form the adhesive layer 4 include adhesives such as thermosetting adhesives and thermoplastic adhesives.

Examples of the thermosetting adhesive include an epoxy adhesive, a thermosetting polyimide adhesive, a phenol adhesive, a urea adhesive, a melamine adhesive, an unsaturated polyester adhesive, a diallyl phthalate adhesive, a silicone adhesive, and a thermosetting urethane adhesive.

Examples of the thermoplastic adhesive include an acrylic adhesive, a rubber adhesive, and a polyolefin adhesive.

As the adhesive, the thermosetting adhesive is preferably used and more preferably, the epoxy adhesive is used.

For example, the epoxy adhesive contains an epoxy resin and a curing agent in appropriate proportions.

Specific examples of the epoxy resin include aromatic epoxy resins such as bisphenol epoxy resin (e.g., bisphenol A epoxy resin, bisphenol F epoxy resin, bisphenol S epoxy resin, hydrogenated bisphenol A epoxy resin, dimer-acid-modified bisphenol epoxy resin, etc.), novolak epoxy resin (e.g., phenol novolak epoxy resin, cresol novolak epoxy resin, biphenyl epoxy resin, etc.), naphthalene epoxy resin, fluorene epoxy resin (e.g., bisarylfluorene epoxy resin, etc.), and triphenylmethane epoxy resin (e.g., trishydroxyphenylmethane epoxy resin, etc.); nitrogen-containing-cyclic epoxy resins such as triepoxypropylisocyanurate (triglycidylisocyanurate), and hydantoin epoxy resin; aliphatic epoxy resin; alicyclic epoxy resin (e.g., dicyclo ring-type epoxy resin, etc.), glycidylether epoxy resin, and glycidylamine epoxy resin.

These epoxy resins may be used singly or in combination of two or more.

The curing agent is a latent curing agent (epoxy resin curing agent) which can cure an epoxy resin through heating. Examples of the curing agent include an amine compound, an acid anhydride compound, an amide compound, a hydrazide compound, and an imidazoline compound. In addition to the compounds shown above, a phenol compound, a urea compound, a polysulfide compound, or the like can also be used.

Examples of the amine compound include polyamines such as ethylenediamine, propylenediamine, diethylenetriamine, and triethylenetetramine, amine adducts thereof, metaphenylenediamine, diaminodiphenylmethane, and diaminodiphenylsulfone.

Examples of the acid anhydride compound include phthalic anhydride, maleic anhydride, tetrahydrophthalic anhydride, hexahydrophthalic anhydride, 4-methyl-hexahydrophthalic anhydride, methylnadic anhydride, pyromellitic anhydride, dodecenylsuccinic anhydride, dichlorosuccinic anhydride, benzophenonetetracarboxylic anhydride, and chlorendic anhydride.

Examples of the amide compound include dicyandiamide and polyamide.

Examples of the hydrazide compound include adipic dihydrazide.

Examples of the imidazoline compound include methylimidazoline, 2-ethyl-4-methylimidazoline, ethylimidazoline, isopropylimidazoline, 2,4-dimethylimidazoline, phenylimidazoline, undecylimidazoline, heptadecylimidazoline, and 2-phenyl-4-methylimidazoline.

These curing agents may be used singly or in combination of two or more.

As necessary, to the epoxy adhesive, a known additive such as, for example, a curing accelerator can also be added in a proper proportion.

Examples of the curing accelerator include imidazole compounds such as 2-phenylimidazole, 2-methylimidazole, 2-ethyl-4-metylimidazole, and 2-phenyl-4-methyl-5-hydroxymethylimidazole, tertiary amine compounds such as triethylenediamine and tri-2,4,6-dimethylaminomethylphenol, phosphorus compounds such as triphenylphosphine, tetraphenylphosphoniumtetraphenylborate, and tetra-n-butylphosphonium-o,o-diethylphosphorodithioate, quaternary ammonium salt compounds, organic metal salt compounds, and derivatives thereof. These curing accelerators may be used singly or in combination of two or more.

The adhesives shown above can also be dissolved in a solvent and prepared as a solution (varnish). Examples of the solvent include organic solvents. Examples of the organic solvent includes ketones such as acetone and methylethylketone, esters such as ethyl acetate, amides such as N-N-dimethylformamide and N-methyl-2-pyrrolidone. Examples of the solvent also include aqueous solvents. Examples of the aqueous solvent include water, and alcohols such as methanol, ethanol, propanol, and isopropanol. Preferably, the organic solvents are used, and more preferably, ketones or amides are used.

To form the adhesive layer 4 on the upper surface of the conductor plate 11, for example, first, the adhesive layer 4 is formed on the surface of the release sheet 12, and thereafter, the adhesive layer 4 is transferred on the surface of the conductor plate 11 from the release sheet 12.

To form the above-described adhesive on the surface of the release sheet 12, the adhesive is applied on the surface of the release sheet 12, for example, by roll coating, blade coating, or gravure coating.

Then, as necessary, the adhesive is dried to distill off the solvent.

Subsequently, when the adhesive material is a thermosetting adhesive, the adhesive material is brought into stage B state (semi-cured state) by heating. The heating temperature is in a range of, for example, 30 to 80 °C, preferably 40 to 60 °C.

The adhesive layer 4 is formed on the surface of the release sheet 12 in this manner.

Thereafter, the adhesive layer 4 provided on the surface of the release sheet 12 is transferred to the upper surface of the conductor plate 11. For the transferring, for example, a roll laminator is used.

In this manner, the adhesive layer 4 with the release sheet 12 provided on its upper surface is laminated on the upper surface of the upper-side low-melting-point metal layer 3.

In this manner, as shown in FIG. 2 (c), a laminate 30, in which the lower-side low-melting-point metal layer 3, the conductor plate 11, the upper-side low-melting-point metal layer 3, the adhesive layer 4, and the release sheet 12 are laminated sequentially, is produced.

Then, as shown in FIG. 2(d), the laminate 30 is pressed with a mold in the thickness direction.

For the mold, for example, a metal mold that is formed with a pattern of the above-described projecting regions 5 and joint regions 6, and that is composed of a male mold and a female mold is used.

The conductive adhesive sheet 1 including the conductor layer 2 provided with the projecting regions 5 that project curvedly towards the upper side thereof; and the low-melting-point metal layer 3, the adhesive layer 4, and the release sheet 12 laminated sequentially on the conductor layer 2 is obtained in this manner.

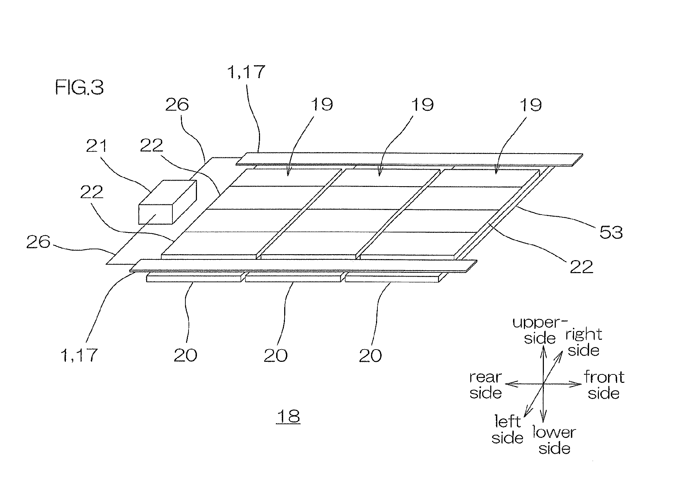

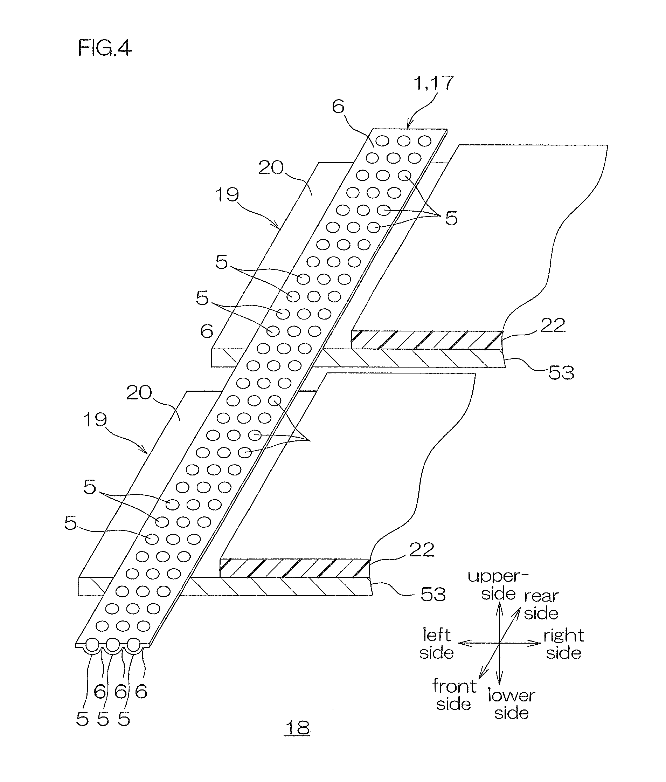

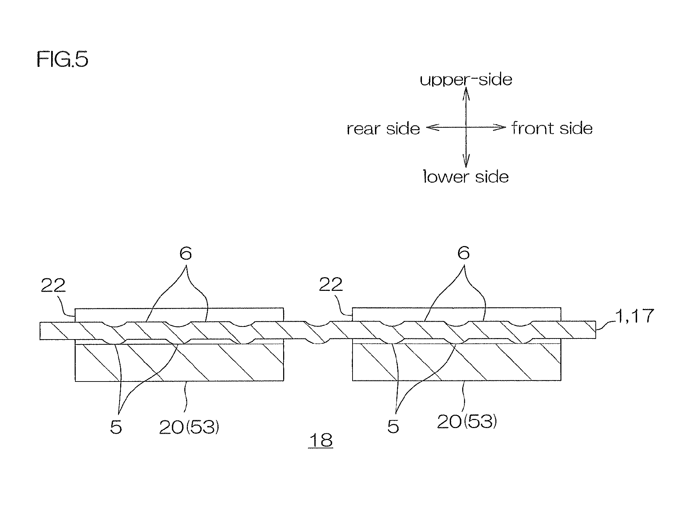

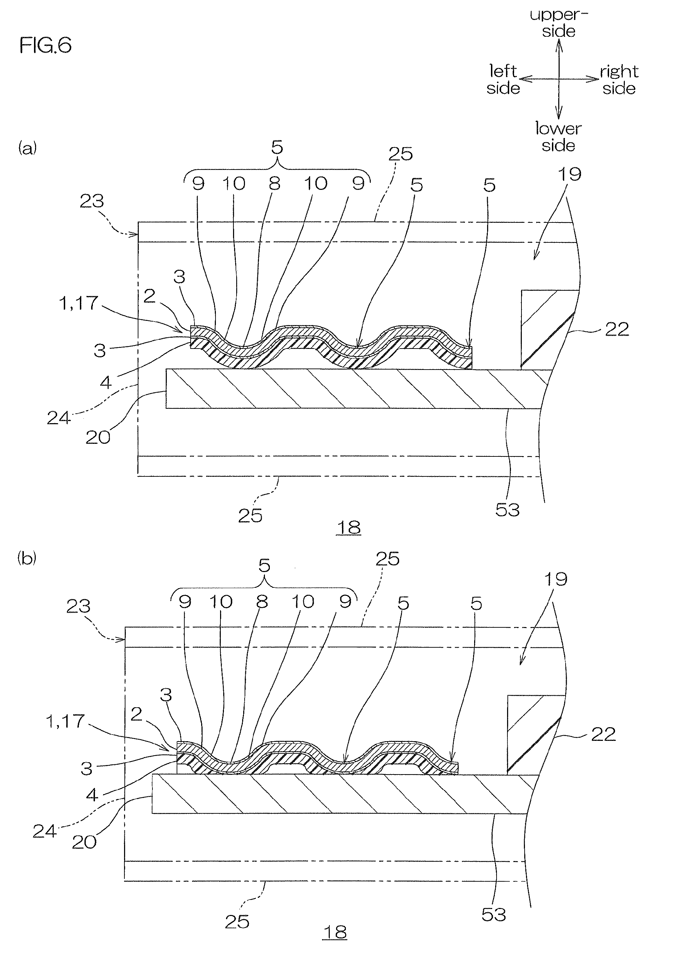

FIG. 3 shows a perspective view of a solar cell module in an embodiment (embodiment in which photoelectric conversion portions are amorphous silicon-based) of the present invention; FIG. 4 shows an enlarged perspective view illustrating a connection structure (left-side portion) between terminals and collector electrodes; FIG. 5 shows a side sectional view of the connection structure of FIG. 4; and FIG. 6 shows a front cross-sectional view of the connection structure of FIG. 4.

In FIG. 3, the projecting regions 5 are omitted to clearly show the relative positions of solar cells 19 and collector electrodes 17. In FIG. 5, the low-melting-point metal layer 3 and the adhesive layer 4 are omitted to clearly show the relative positions of the projecting regions 5 and the terminals 20.

Next, description is given below of an embodiment (embodiment in which photoelectric conversion portions are amorphous silicon-based) of the solar cell module of the present invention, in which the conductive adhesive sheet 1 is used as the collector electrode 17, with reference to FIG. 3 to FIG. 6.

In FIG. 3, a solar cell module 18 includes solar cells 19 and collector electrodes 17. The solar cell module 18 also includes a retrieval portion 21 and a protective portion 23 (see phantom line in FIG. 6 (a) and FIG. 6 (b)).

The plurality of solar cells 19 are arranged in parallel in front-rear directions, and each of the solar cells 19 is formed in a generally rectangular shape having longer sides in left-right directions when viewed from the top. The solar cell 19 also includes a wiring plate 53 and a photoelectric conversion portion 22.

The wiring plate 53 is formed at the lower surface of the photoelectric conversion portion 22, and has the outline shape of the solar cell 19. To be specific, the wiring plate 53 is formed in a generally rectangular shape extending in left-right directions when viewed from the top.

The photoelectric conversion portion 22 is formed of, for example, amorphous-silicon-based solar cell elements on the upper surface of the wiring plate 53. The plurality of solar cell elements are arranged in parallel in left-right directions. The photoelectric conversion portion 22 generates carriers (electrons or holes) by receiving sunlight. The photoelectric conversion portion 22 is disposed in the middle (center) of the wiring plate 53 in the left-right directions so as to expose the both end portions in left-right directions of the wiring plates 53.

The both end portions in left-right directions of the wiring plate 53 having upper surface thereof exposed from the photoelectric conversion portion 22 are used as terminals 20.

Two collector electrodes 17 are formed of the above-described conductive adhesive sheet 1, and are disposed to extend in front-rear directions so as to connect the terminals 20. That is, one (on the right) of the collector electrodes 17 is provided so as to electrically connect the terminals 20 disposed at the right end portion of the photoelectric conversion portions 22. On the other hand, the other (on the left) collector electrode 17 is provided so as to electrically connect the terminals 20 disposed at the left end portion of the photoelectric conversion portions 22.

As shown in FIG. 5 and FIG. 6(b), the collector electrodes 17 are disposed in a manner such that the projecting regions 5 are brought near the upper surface of the terminal 20. To be specific, the collector electrode 17 adheres to the upper surface of the terminal 20 so that the projecting regions 5 project downwardly. That is, the collector electrode 17 is allowed to adhere to the upper surface of the terminal 20 so that the adhesive layer 4 is disposed below and the conductor layer 2 is disposed above.

In the conductor layer 2, the top portions 8 of the projecting regions 5 are welded (metal welded) to the terminals 20 through the low-melting-point metal layer 3.

Furthermore, the adhesive layer 4 positioned below the middle portion 10 and the bottom portion 9 of the projecting region 5 is allowed to adhere to the upper surface of the terminal 20.

As shown in FIGs. 3 to 5, the collector electrodes 17 are disposed (to span) over the plurality of terminals 20 disposed in parallel in front-rear directions.

As shown by the phantom line in FIG. 6 (b), the protective portion 23 is provided to protect the solar cells 19 and the collector electrodes 17, and includes a sealing layer 24 and glass plates 25.

The solar cells 19 and the collector electrodes 17 are sealed (embedded) in the sealing layer 24. That is, the sealing layer 24 is formed over, under, and around the solar cells 19 and the collector electrodes 17. Examples of a material for forming the sealing layer 24 include sealing resins such as an ethylene-vinyl acetate copolymer (EVA) and polyvinyl butyral (PVB). The melting temperature for the sealing resin is, for example, 40 to 70°C, and the curing (crosslinking) temperature is, for example, 120 to 180°C.

Two glass plates 25 are formed so as to cover the upper surface and the lower surface of the sealing layer 24.

As shown in FIG. 3, the retrieval portion 21 is not protected by the above-described protective portion 23; is provided at a region exposed from the protective portion 23; and is connected to two collector electrodes 17 via wirings 26.

To produce the solar cell module 18, for example, a plurality of solar cells 19 are prepared, and collector electrodes 17 composed of the conductive adhesive sheet 1 are prepared.

Then, as shown in FIG. 6 (a) and FIG. 6 (b), the lower glass plate 25 is prepared, and on the lower glass plate 25, a lower portion of the sealing layer 24 is formed, and then on the lower portion of the sealing layer 24, a plurality of solar cells 19 are disposed.

Then, as shown by the phantom line and arrow in FIG. 2(d), the release sheet 12 is released from the adhesive layer 4, and thereafter, after the collector electrode 17 (conductive adhesive sheet 1) is flipped over (upside down), the projecting regions 5 and the adhesive layer 4 of the collector electrode 17 are disposed to face the upper surface of the terminals 20, placing the projecting regions 5 and the adhesive layer 4 on the upper surface of the terminals 20.

To be specific, as shown in FIG. 6 (a), first, the adhesive layer 4 at the projecting regions 5 is brought into contact with the upper surface of the terminal 20.

Then, the upper side and surrounding of the solar cells 19 and the collector electrodes 17 are covered with the sealing layer 24, and subsequently, the upper surface of the sealing layer 24 is covered with the upper-side glass plate 25. A laminate is made in this manner.

Thereafter, the laminate is heated.

The heating temperature is, for example, 130 to 200°C, preferably 120 to 160°C, and the heating time is, for example, 5 to 60 min, preferably 5 to 40 min.

Simultaneously with the heating described above, compression (i.e., thermocompression) can also be performed. The pressure is, for example, 0.5 to 10 MPa, preferably 1 to 5 MPa.

By the heating, the sealing resin of the sealing layer 24 is melted and cured (crosslinked) to seal in the solar cells 19 and the collector electrodes 17.

Also, by the heating and the compressing, as shown in FIG. 6 (b), the adhesive layer 4 formed below the top portion 8 of the projecting region 5 of the collector electrode 17 is softened or melted so that the adhesive layer 4 moves toward the middle portion 10 and the bottom portion 9. That is, the adhesive layer 4 at the top portion 8 is slowly pushed out.

Thus, the low-melting-point metal layer 3 at the top portion 8 is exposed.

Then, because the metal that forms the low-melting-point metal layer 3 at the top portion 8 is melted, the lower surface of the top portion 8 of the conductor layer 2 and the upper surface of the terminal 20 are welded through the metal. At the same time, the adhesive layer 4 moved to the middle portion 10 and the bottom portion 9 is cured, when the adhesive material is a thermosetting adhesive, by the curing (complete curing) of the thermosetting adhesive, and the top portion 8 is allowed to adhere to the upper surface of the terminal 20.

As a result, the collector electrodes 17 are allowed to strongly adhere to the terminals 20, while conduction occurs between the collector electrodes 17 and the terminals 20.

Thereafter, as shown in FIG. 3, the collector electrode 17 are connected to the retrieval portion 21 either directly or via the wirings 26.

The solar cell module 18 is obtained in this manner.

In the solar cell module 18, by the reception of sunlight by the photoelectric conversion portions 22, carriers are generated, and the generated carriers are collected through the plurality of terminals 20 by the two collector electrodes 17, and retrieved as electricity from the retrieval portion 21.

In the conductive adhesive sheet 1, the low-melting-point metal layer 3 and the adhesive layer 4 are laminated sequentially on the upper side of the conductor layer 2, and therefore by allowing the conductive adhesive sheet 1 to abut on the terminals 20 disposed on the upper side, the low-melting-point metal layer 3 and the adhesive layer 4 at the projecting regions 5 that project toward the upper side are brought into contact with the terminals 20, and then while the top portions 8 are pushing aside the low-melting-point metal layer 3 and the adhesive layer 4, the top portions 8 are brought into contact with the terminals 20. Then, because the projecting regions 5 project curvedly, concentration of excessive stress on the terminal 20 can be relaxed.

Thus, damages to the terminals 20 can be suppressed.

Furthermore, because the contact area with the projecting regions 5 that project curvedly can be made relatively larger, excellent conductivity between them can be ensured.

Moreover, because the adhesive layer 4 can ensure the contact state with the terminal 20, the conductive adhesive sheet 1 is allowed to adhere reliably to the terminals 20.

Furthermore, by melting the metal that forms the low-melting-point metal layer 3, the projecting regions 5 and the terminals 20 are strongly bonded, and therefore even more excellent conductivity can be ensured.

Furthermore, the collector electrode 17 composed of the conductive adhesive sheet 1 achieves less damage to the solar cells 19, and ensures collection of carriers generated in solar cells 19. Thus, the solar cell module 18 including the solar cells 19 and the collector electrodes 17 is excellent in power generation efficiency.

In a method for producing a conductive adhesive sheet 1, a laminate 30 in which a conductor plate 11, an adhesive layer 4, and a release sheet 12 laminated sequentially is produced. That is, the adhesive layer 4 is sandwiched in the thickness direction and supported by the conductor plate 11 and the release sheet 12. Thus, even if the laminate 30 is pressed in the thickness direction with a mold, pushing of the adhesive layer 4 over to the joint region 6 from the region where the projecting region 5 is formed can be suppressed, allowing formation of the projecting regions 5 with the adhesive layer 4 remaining.

Furthermore, the release sheet 12 allows prevention of contamination by the adhesive layer 4 adhering to the surrounding members.

Although in embodiments of FIG. 1 to FIG. 6, the low-melting-point metal layer 3 is formed on both sides of the upper surface and the lower surface of the conductor layer 2, for example, although not shown, the low-melting-point metal layer 3 can be formed only on the upper surface of the conductor layer 2.

This embodiment also achieves the same operations and effects as those of the embodiment of FIG. 1 to FIG. 6.

Although in the embodiment of FIG. 1 to FIG. 6, the upper-side low-melting-point metal layer 3 and the adhesive layer 4 are provided entirely on the conductor layer 2 including the projecting region 5, for example, although not shown, the low-melting-point metal layer 3 and the adhesive layer 4 can be provided only on the projecting regions 5.

This embodiment also achieves the same operations and effects as those of the embodiment of FIG. 1 to FIG. 6.

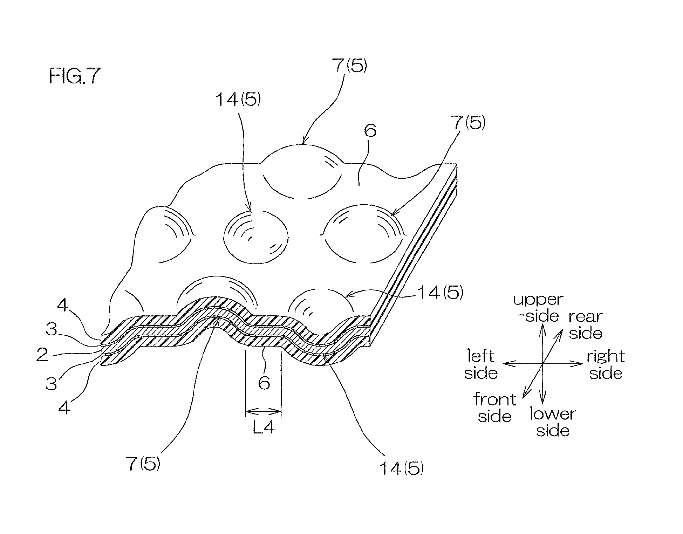

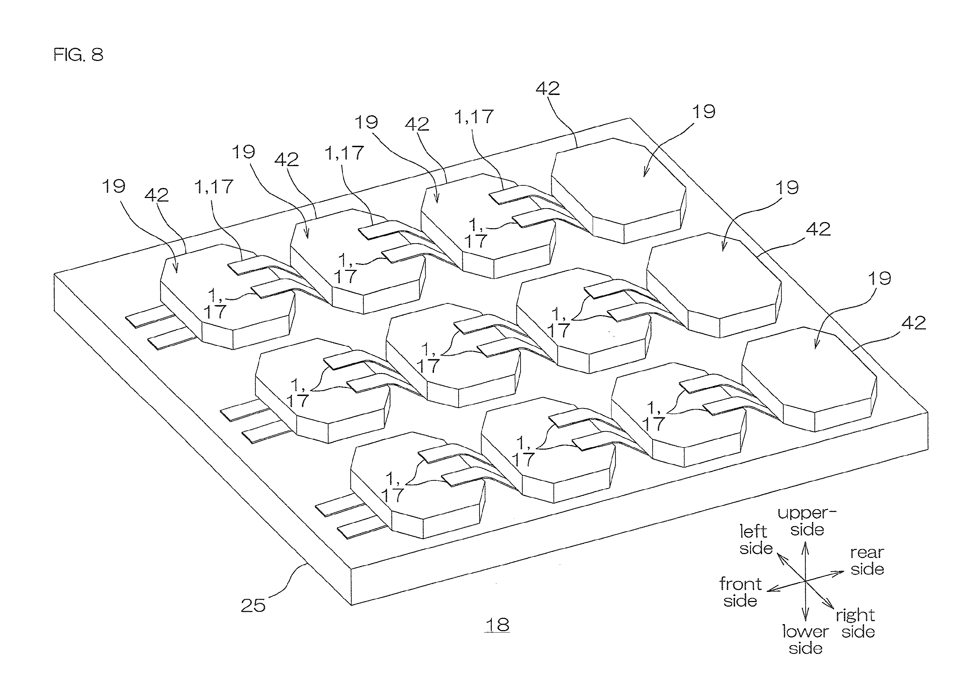

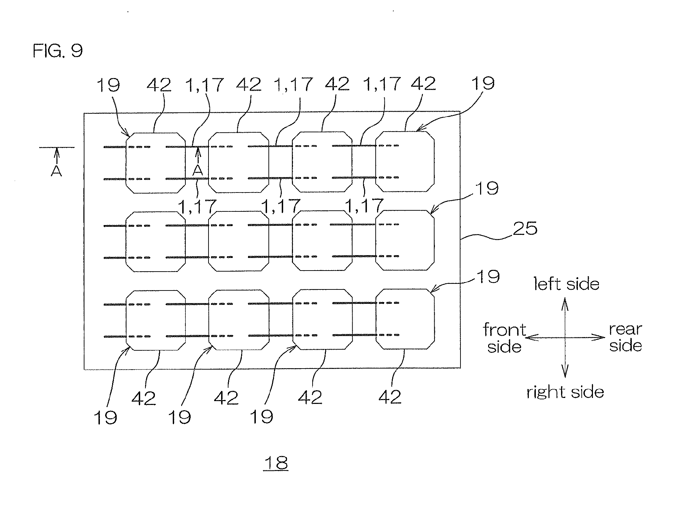

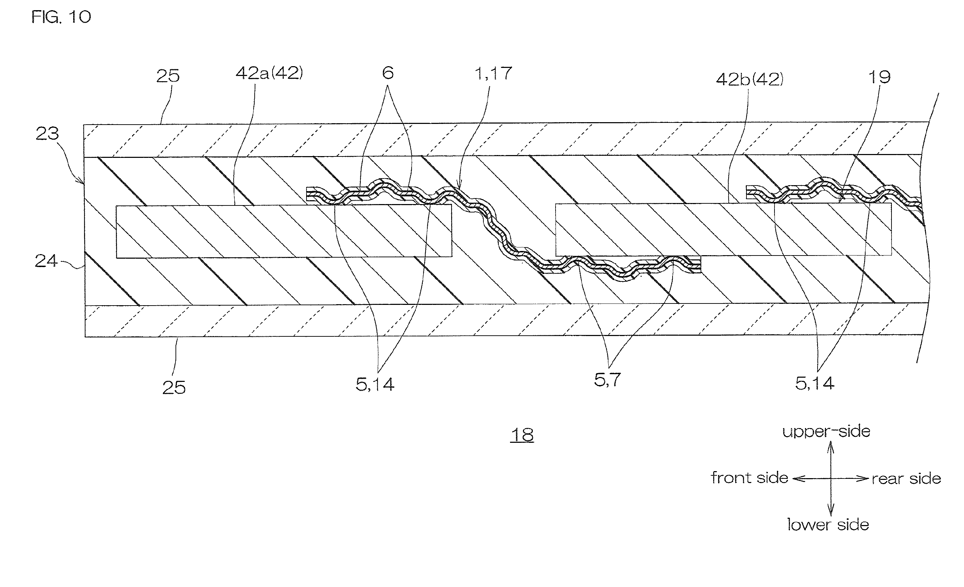

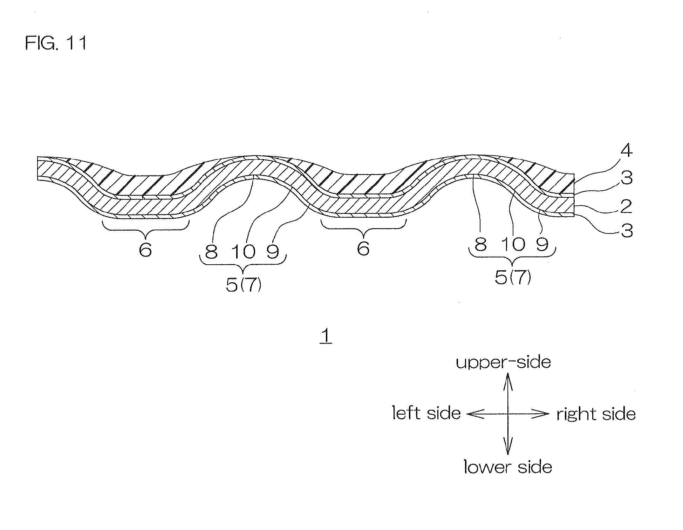

FIG. 7 shows a perspective view of a conductive adhesive sheet in another embodiment (embodiment in which the projecting region includes an upper portion and a lower portion) of the present invention; FIG. 8 shows a perspective view of the solar cell module in another embodiment (embodiment in which the photoelectric conversion portion is crystalline silicon-based) of the present invention; FIG. 9 shows a plan view of the solar cell module shown in FIG. 8; FIG. 10 shows an enlarged view of the solar cell module of FIG. 9, i.e., a side sectional view taken along line A-A; and FIG. 11 shows a cross-sectional view of the conductive adhesive sheet in another embodiment of the present invention. In FIGs. 8 and 9, the projecting region 5 and the protective portion 23 are omitted to clearly show the relative positions of the collector electrode 17 and the solar cell 19.

In the following Figures, members corresponding to the above-described elements are designated with the same reference numerals, and detailed descriptions thereof are omitted.

Although the adhesive layer 4 is formed only on the upper side of the conductor layer 2 in the embodiments of FIG. 1 to FIG. 6, for example, as shown in FIG. 7, the adhesive layer 4 can be formed on both sides, i.e., the upper side and the lower side of the conductor layer 2.

In FIG. 7, the conductive adhesive sheet 1 includes a conductor layer 2; low-melting-point metal layers 3 formed above and below the conductor layer 2; and adhesive layers 4 formed above the upper-side low-melting-point metal layer 3 and below the lower-side low-melting-point metal layer 3.

The projecting region 5 includes an upper portion 7 that project curvedly from a joint region 6 towards the upper side, and a lower portion 14 that project curvedly from the joint region 6 toward the lower side.

The lower portion 14 is formed into a shape of an inverted upper portion 7.

The upper portions 7 and the lower portions 14 are disposed alternately in left-right directions. The upper portions 7 and the lower portions 14 are disposed alternately also in front-rear directions.

Distance L4 between the upper portion 7 and the lower portion 14 in front-rear directions and left-right directions is, for example, 0.1 to 5.0 µm, preferably 0.1 to 3.0 µm.

To produce the conductive adhesive sheet 1 of FIG. 7, as shown in FIG. 2 (a), first, the conductor plate 11 is prepared, and then, as shown in FIG. 2 (b), the low-melting-point metal layer 3 is formed on the upper surface and the lower surface of the conductor plate 11.

Then, as shown in FIG. 2 (c) and FIG. 7, the adhesive layer 4 formed on the surface of the release sheet 12 is transferred to both of the upper surface of the upper-side low-melting-point metal layer 3 and the lower surface of the lower-side low-melting-point metal layer 3, thereby producing a laminate 30. Thereafter, as shown in FIG. 7, the laminate 30 is pressed with a mold in the thickness direction.

The conductive adhesive sheet 1 including a conductor layer 2 having upwardly and downwardly projecting projecting regions 5; and low-melting-point metal layers 3, adhesive layers 4, and release sheets 12 sequentially laminated above and below the conductor layer 2 is obtained in this manner.

Next, description is given below of another embodiment (embodiment in which the photoelectric conversion portion is crystalline silicon-based) of the solar cell module of the present invention, in which the conductive adhesive sheet 1 shown in FIG. 7 is used as a collector electrode 17, with reference to FIG. 8 to FIG. 10.

In FIGs. 8 and 9, in the solar cell module 18, the plurality of solar cells 19 are arranged to align in the front-rear directions and in the left-right directions. Each of the solar cells 19 is formed into a generally rectangular shape when viewed from the top, and includes a photoelectric conversion portion 42 and terminals (not shown).

The photoelectric conversion portion 42 is, for example, a monocrystalline or polycrystalline silicon-based solar cell element. The photoelectric conversion portion 42 is formed over substantially the entire surface (surface excluding the terminal) of the solar cells 19, and two terminals (not shown) are provided on the upper surface and on the lower surface of the photoelectric conversion portion 42.

The upper surface of the upper-side terminal is exposed, and the lower surface of the lower-side terminal is exposed.

The collector electrode 17 is composed of the conductive adhesive sheet 1 shown in FIG. 7, and as shown in FIGs. 8 and 9, electrically connects the solar cells 19 disposed in parallel in front-rear directions so as to extend narrowly along front-rear directions. Specifically, the collector electrode 17 connects the photoelectric conversion portions 42 which are adjacent in front-rear directions. The two collector electrodes 17 are provided in parallel in spaced-apart relation to each other in left-right directions, as shown in FIGs. 8 and 9, for each photoelectric conversion portion 42.

Next, description is given below of a connection structure of the photoelectric conversion portions 42 by the collector electrodes 17 with reference to FIG. 8 to FIG. 10, using two photoelectric conversion portions 42 that are adjacent to each other in front-rear directions.

The two photoelectric conversion portions 42 that are adjacent to each other in front-rear directions include a front photoelectric conversion portion (hereinafter referred to as "front portion") 42a, and a rear photoelectric conversion portion (hereinafter referred to as "rear portion") 42b disposed behind the front portion 42a in spaced-apart relation to each other.

The front end portion of the collector electrode 17 is electrically connected to the terminal formed over the front portion 42a, and the rear end portion of the collector electrode 17 is electrically connected to the terminal formed below the rear portion 42b.

To be specific, as shown in FIG. 7 and FIG. 10, in the front end portion of the collector electrode 17, the lower portion 14 of the projecting region 5 is in contact with the upper surface of the terminal (not shown) formed on the upper side of the front portion 42a, and the lower-side adhesive layer 4 is in contact with the upper surface of the above-described terminal (not shown). Also, the lower-side low-melting-point metal layer 3 (ref: FIG. 7) is welded to the upper surface of the above-described terminal (not shown).

On the other hand, in the rear end portion of the collector electrode 17, the upper portion 7 of the projecting region 5 is in contact with the lower surface of the terminal (not shown) formed below the rear portion 42b, and the upper-side projecting region 5 is allowed to adhere to the lower face of the above-described terminal (not shown). Also, the upper-side low-melting-point metal layer 3 (ref: FIG. 7) is welded to the lower surface of the above-described terminal (not shown).

That is, in the collector electrode 17, the upper portions 7 and the lower portions 14 of the projecting regions 5 are in contact with the terminals (not shown) formed below the rear portion 42b and above the upper side of the front portion 42a, respectively, and the adhesive layers 4 on the upper side and the lower side are in contact with the terminals (not shown) formed below the rear portion 42b and above the front portion 42a, respectively. Furthermore, the upper-side low-melting-point metal layers 3 and the lower-side low-melting-point metal layers 3 are welded to the terminal (not shown) formed below the rear portion 42b and the terminal (not shown) formed above the front portion 42a, respectively.

Each of the collector electrodes 17 electrically connects the photoelectric conversion portions 42 of the mutually adjacent solar cells 19, thereby connecting the solar cells 19 arranged in parallel in the front-rear directions in series.

Although not shown in FIGs. 8 and 9, the collector electrode 17 that connects the frontend solar cell 19 is connected to the retrieval portion 21 (ref: FIG. 3), and the solar cell 19 and the collector electrode 17 are protected by the protective portion 23 (phantom line in FIG. 6(a) and FIG. 6 (b)).

Then, with the collector electrode 17 composed of the conductive adhesive sheet 1 shown in FIG. 7, a solar cell 19 in which a crystalline silicon-based solar cell element is used as the photoelectric conversion portion 42 can also be connected.

Furthermore, in the embodiment of FIG. 1, the adhesive layer 4 is formed on the entire upper surface of the upper-side low-melting-point metal layer 3. However, for example, as shown in FIG. 11, the adhesive layer 4 can also be formed on the upper surface of the upper-side low-melting-point metal layer 3 at the middle portion 10 and at the bottom portion 9 of the upper portion 7, and also on the upper surface of the upper-side low-melting-point metal layer 3 at the joint region 6, so as to expose the upper-side low-melting-point metal layer 3 at the top portion 8 of the upper portion 7 in the projecting region 5.

In the embodiment of FIG. 11, the upper-side low-melting-point metal layer 3 is exposed from the surrounding adhesive layer 4, at the top portion 8 of the upper portion 7 of the projecting region 5, and therefore can be easily welded (metal bonded) with the terminal 20 (ref: FIG. 6 (b)).

On the other hand, the above-described adhesive layer 4 surrounding the top portion 8, that is, the adhesive layer 4 formed on the upper surface of the upper-side low-melting-point metal layer 3 at the middle portion 10 and at the bottom portion 9 of the upper portion 7, and formed on the upper surface of the upper-side low-melting-point metal layer 3 at the joint region 6 can be allowed to adhere to the terminal 20 (ref: FIG. 6 (b)).

The above-described conductive adhesive sheet can also be used, for example, as a conductive adhesive tape or a conductive adhesive film.

In the above description, the conductive adhesive sheet 1 is used as the collector electrode 17 in the solar cell module 18. However, use of the conductive adhesive sheet 1 is not particularly limited, and the conductive adhesive sheet 1 can be used, for example, for connection between connection terminals of various electrical devices other than the solar cell module 18.

### Example

Hereinafter, the present invention is described in further detail with reference to Examples. However, the present invention is not limited to those described in Examples.

### Example 1

A conductor plate (copper plate thickness 35 µm) composed of copper and having a thickness (T1) of 35 µm was prepared (ref: FIG. 2 (a)). The conductor plate was provided with a low-melting-point metal layer composed of tin and having a thickness (T3) of 5 µm on the upper surface and the lower surface thereof.

Then, an epoxy adhesive containing 100 parts by mass of epoxy resin (bisphenol A epoxy resin, epoxy equivalent 600 to 700g/eqiv.), 4 parts by mass of a curing agent (phenol compound), and 1 part by mass of a curing accelerator (imidazole compound) was applied on the surface of a release sheet, and thereafter, the epoxy adhesive was dried. Subsequently, the epoxy adhesive was heated to 40 to 60°C to be brought into B-STAGE state (semi-cured state), thereby producing an adhesive layer having a thickness (T4) of 40 µm laminated on the surface of the release sheet. Thereafter, the adhesive layer was transferred from the release sheet by a roll laminator to the entire upper surface of the upper-side low-melting-point metal layer, thereby producing a laminate (ref: FIG. 2 (c)).

Thereafter, by pressing the laminate in the thickness direction with a metal mold formed with a pattern of the projecting regions and joint regions, the above-described projecting regions were formed in the conductor layer (ref: FIG. 2(d)).

The projecting regions were formed into a generally circular shape when viewed from the top, projecting curvedly toward the upper side. The sizes of the projecting regions are, as shown in FIG. 1, as follows: the pitch (L1) between the top portions was 1.0 mm; the external diameter (L2) of the projecting region was 0.8 mm; the projection length (T2) was 0.21 mm; and the radius of curvature (R) was 0.4 mm.

## Claims

1. A conductive adhesive sheet comprising:
a conductor layer including a projecting region that projects curvedly toward at least one side in the thickness direction;
a low-melting-point metal layer that is formed on at least one surface in the thickness direction of the projecting region; and
an adhesive layer formed on at least one surface in the thickness direction of the low-melting-point metal layer.

2. The conductive adhesive sheet according to Claim 1, wherein the low-melting-point metal layer comprises tin and/or a tin-bismuth alloy.

3. The conductive adhesive sheet according to Claim 1 or 2, wherein the conductor layer comprises copper.

4. The conductive adhesive sheet according to Claim 1, 2 or 3, wherein the projecting region comprises a plurality of projecting regions disposed in a direction perpendicular to the thickness direction in spaced-apart relation to each other.

5. A collector electrode for collecting carriers generated in a solar cell,
the collector electrode comprising a conductive adhesive sheet according to any of claims 1 to 4.

6. A solar cell module comprising a solar cell and a collector electrode according to claim 5, wherein the collector electrode collects carriers generated in the solar cell.

7. A method for producing a conductive adhesive sheet comprising:
preparing a conductor plate;
transferring an adhesive layer laminated on a release sheet on at least one surface in the thickness direction of the conductor plate, thereby producing a laminate having the conductor plate, the adhesive layer, and the release sheet that are sequentially laminated; and
pressing the laminate with a mold in the thickness direction, thereby forming a conductor layer including a projecting region that projects curvedly toward at least one side in the thickness direction.

8. The method for producing a conductive adhesive sheet according to Claim 7, wherein in the step of preparing the conductor plate, the conductor plate is provided with a low-melting-point metal layer formed on at least one surface in the thickness direction.
